# EUROPEAN PATENT APPLICATION

(11) **EP 4 557 366 A1**
(43) Date of publication of application: **21.05.2025**
(21) Application number: 24212417.0
(22) Date of filing: 12.11.2024
(51) Int. Cl.: H01L 25/065, H01L 23/367, H01L 23/498, H01L 23/538

(54) **MULTIDIE FLIP CHIP PACKAGE WITH HEAT SINK**

(30) Priority: 16.11.2023 US 202363599651 P; 07.10.2024 US 202418907998
(71) Applicant: STMicroelectronics International N.V., 1228 Plan-les-Ouates, Geneva (CH)
(72) Inventor: TALLEDO, Jefferson Sismundo, 4027 Calamba (PH)
(74) Representative: Casalonga

(57) **Abstract**

A substrate includes a center portion and a peripheral portion connected to the center portion by a flexible coupling region. A first die is mounted to an upper surface of the substrate at the center portion and a second die is mounted to the upper surface of the substrate at the peripheral portion. A heatsink includes a base plate, fins extending from an upper surface of the base plate and tabs extending from a lower surface of the base plate. The tabs of the heatsink are mounted to the upper surface of the substrate at the center portion, and the lower surface of the base plate is thermally coupled to a back of the first die. The peripheral portion is folded relative to the center portion at the flexible coupling region. An outer surface of the fin of the heatsink is thermally coupled to a back of the second device.

## Description

### CROSS REFERENCE TO RELATED APPLICATIONS

This application claims priority from United States Provisional Application for Patent No. 63/599,651, filed November 16, 2023, the disclosure of which is incorporated herein by reference.

### TECHNICAL FIELD

The present invention relates to three-dimensional (3D) packages for multiple integrated circuit dies.

### BACKGROUND

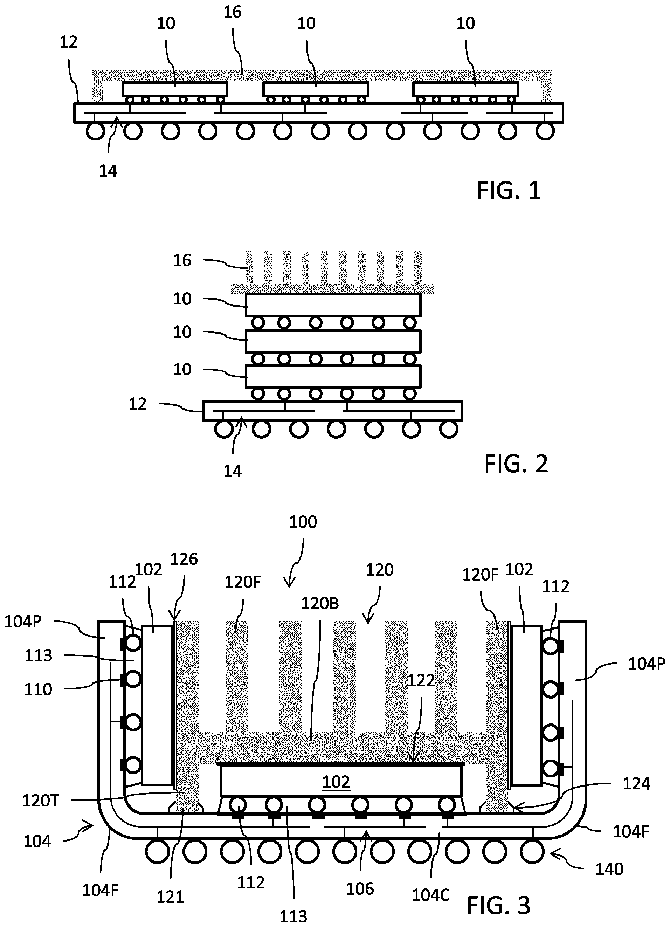

Advanced packaging for integrated circuit dies may provide a configuration like that shown in Figure 1 where multiple integrated circuit dies 10 are mounted (in flip chip orientation) to the upper surface of a support substrate 12 (including a power/signal routing network 14) and share an overlying heatsink 16 thermally coupled to the dies and mounted to the substrate, or a configuration like that shown in Figure 2 wherein the multiple integrated circuit dies 10 are stacked one on top of the other (in flip chip orientation with through silicon vias (TSVs) in a thermally and electrically coupled relationship), supported by an underlying support substrate 12 (including a power/signal routing network 14) and capped with a heatsink 16 thermally coupled to an upper-most one of the dies.

The packaging solution illustrated in Figure 1 suffers from the drawbacks associated with the side-by-side die configuration of necessitating longer interconnects between dies and having a package footprint which occupies an overly large area. The packaging solution illustrated in Figure 2 suffers from the drawbacks associated with the stacked die configuration of being overly complex, expensive and having constraints in heat dissipation.

There is a need in the art for a better packaging solution for multiple integrated circuit dies. Preferably, the packaging solution would provide both a reduced package footprint and improved heat dissipation in comparison to packaging solutions like that shown in Figures 1 and 2.

### SUMMARY

In an embodiment, a package comprises: a support substrate including routing network; wherein the support substrate includes a center portion and at least one peripheral portion connected to the center portion by a flexible coupling region; a first circuit device having a front mounted to an upper surface of the support substrate at the center portion and electrically coupled to the routing network; a second circuit device having a front mounted to the upper surface of the support substrate at the at least one peripheral portion and electrically coupled to the routing network; a heatsink comprising a base plate, a plurality of fins extending from an upper surface of the base plate and a plurality of tabs extending from a lower surface of the base plate; wherein the tabs of the heatsink are mounted to the upper surface of the support substrate at the center portion, and the lower surface of the base plate is thermally coupled to a back of said first circuit device; wherein the at least one peripheral portion is folded relative to the center portion at the flexible coupling region; and wherein an outer surface of at least one fin of the heatsink is thermally coupled to a back of said second circuit device.

In an embodiment, a package comprises: a support substrate including routing network; wherein the support substrate includes a center portion and at least one peripheral portion connected to the center portion by a flexible coupling region; a first circuit device having a front mounted to an upper surface of the support substrate at the center portion and electrically coupled to the routing network; a second circuit device having a front mounted to the upper surface of the support substrate at the at least one peripheral portion and electrically coupled to the routing network; a heatsink comprising a base plate and a plurality of tabs extending from a lower surface of the base plate; wherein the tabs of the heatsink are mounted to the upper surface of the support substrate at the center portion, and the lower surface of the base plate is thermally coupled to a back of said first circuit device; wherein the at least one peripheral portion is folded relative to the center portion at the flexible coupling region; and wherein an outer surface of at least one tab of the heatsink is thermally coupled to a back of said second circuit device.

### BRIEF DESCRIPTION OF THE DRAWINGS

For the understanding of the present invention, embodiments thereof are now described, purely as a non-limitative example, with reference to the enclosed drawings, wherein:
Figure 1 illustrates a package for multiple integrated circuit dies;
Figure 2 illustrates a package for multiple integrated circuit dies;
Figure 3 illustrates a package for multiple integrated circuit dies;
Figure 4 illustrates an unfolded plan (top) view of the support substrate used in the package of Figure 3; and
Figure 5 shows integrated circuit dies mounted to the support substrate.

### DETAILED DESCRIPTION

The following description refers to the arrangement shown in the drawings; consequently, expressions such as "above", "below", "upper", "lower", "top", "bottom", "right", "left" and the like are relative to the attached Figures and should not be interpreted in a limiting way.

The illustrations in the attached Figures are not necessary drawn to scale and certain features have been exaggerated in size, shape, extent, etc., in order to more clearly show the subject matter.

Figure 3 illustrates a package 100 for multiple integrated circuit dies 102. A flexible multi-layer support substrate 104 includes a power/signal routing network 106. The support substrate 104 includes a center portion 104C and at least one peripheral portion 104P. The peripheral portions 104P are foldable with respect to the center portion 104C at flexible fold areas 104F (comprising, for example, a flexible coupling region of the support substrate 104). In a preferred, but not limiting, implementation, the peripheral portions 104P are folded at a 90° angle with respect to the center portion 104C.

In an embodiment, the flexible multi-layer support substrate 104 may be rigid (or substantially rigid) at the peripheral portions 104P and the center portion 104C, while being flexible at the flexible fold areas 104F.

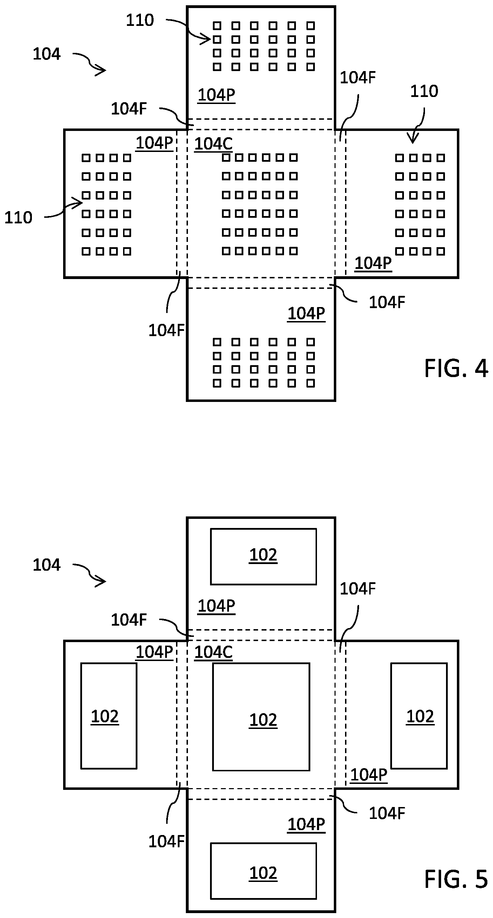

Figure 4 illustrates an unfolded plan (top) view of the support substrate 104. The upper surface of the support substrate 104 includes, at each of the peripheral portions 104P and the center portion 104C, an array of interconnect pads 110. These interconnect pads are electrically connected to the power/signal routing network 106. The integrated circuit dies 102 are mounted to the upper surface of the support substrate 104 in flip chip orientation (i.e., with the front of the die facing the support substrate 104) as shown in Figure 5. The interconnect balls 112 (or pillars) of the integrated circuit die 102 are soldered to the array of interconnect pads 110. A suitable adhesive fill may be provided to encapsulate the interconnect balls 112 and secure the integrated circuit die 102 to the support substrate 104.

In an embodiment, the center portion 104C of the support substrate 104 may have a quadrilateral (square or rectangular) shape, with each of the peripheral portions 104P also having a quadrilateral (square or rectangular) shape. Each peripheral portion 104P, coupled by a flexible coupling region at the flexible fold area 104F, extends perpendicularly away from a side of the quadrilateral shape. While a quadrilateral shape for the center portion 104C of the support substrate 104 is a preferred embodiment, it will be understood that the center portion 104C may instead have some other geometric shape (such as a triangle shape, pentagon shape, or hexagon shape) determined, for example, by the number of integrated circuit dies 102 to be included in the package 10.

With reference once again to Figure 3, the package 100 further includes a heat sink 120. The heat sink 120 includes a base plate 120B with a plurality of fins 120F extending from an upper surface of the base plate 120B. The heat sink 120 further includes a plurality of tabs 120T extending from a lower surface of the base plate 120B. The base plate 120B, fins 120F and tabs 120T form a unitary solid body (for example, made of aluminum or copper) that is manufactured as a single piece of material using suitable fabrication techniques such as milling, casting, extrusion or molding, for example.

The lower surface of the base plate 120B is positioned in thermal contact with the back of the integrated circuit die 102 mounted to the center portion 104C of the support substrate 104. A layer of a thermally conductive adhesive 122 is used between the lower surface of the base plate 120B and the back of the integrated circuit die 102. The distal ends 121 of the tabs 120T are positioned in contact with the upper surface of the support substrate 104 at the center portion 104C. A suitable adhesive 124, for example an epoxy, is used to secure the tabs 120T of the heat sink 120 to the upper surface of the center portion 104C of the support substrate 104.

The peripheral portions 104P, with the integrated circuit dies 102 mounted thereto, are then folded at the flexible fold areas 104F with a 90° angle with respect to the center portion 104C. A layer of a thermally conductive adhesive 126 is used to secure the back of each integrated circuit die 102 mounted to a peripheral portion 104P to the outer surface(s) of the fin(s) 120F of the heat sink 120. It will also be noted that each tab 120T is aligned with a corresponding one of the fins 120F. With this configuration, the back of each integrated circuit die 102 mounted to the peripheral portion 104P is also secured by the layer of thermally conductive adhesive 126 to the outer surface(s) of the tab 120T of the heat sink 120. This serves to provide a larger heat dissipation area of the heatsink in thermal contact with the die 102.

Although Figures 4-5 show an implementation for a package supporting five integrated circuit dies 102, it will be understood that this is by example only and that the package may instead be made with two, three or four integrated circuit dies 102 by adjusting the number of peripheral portions 104P that are included in the support substrate 104.

In an implementation, the integrated circuit dies 102 are component parts of an electronic system where, for example, one of the dies may be a processor or controller integrated circuit, another one of the dies may be a memory integrated circuit, another one of the dies may be a communications integrated circuit, and another one of the dies may be a power management circuit.

In an implementation, one or more of the dies may instead comprise a packaged circuit component. Such a circuit component could be an active or passive component. The packaged circuit component could comprise a packaged integrated circuit, such as provided with a quad flat no-leads (QFN) type packaging or other surface mount packing configuration.

To permit the package to be electrically connected to other circuitry, and further to be mounted to a printed circuit board (PCB), the bottom of the support substrate 104 at the center portion 104C includes a plurality of contact balls 140 (for example, in a ball grid array (BGA) format) that are electrically connected to the power/signal routing network 106.

The package of Figure 3 has a number of advantages over the prior art: a) the package is compact with a small footprint; b) the heatsink is shared by all integrated circuit dies to provide for improved and efficient heat dissipation; c) the adhesive mounting of the tabs to the upper surface of the support substrate in connection with adhesively securing a surface of the heat sink to the back of each die provides for improved package rigidity and obviates the need for additional securing structures such as clamps, straps or caps.

While the invention has been illustrated and described in detail in the drawings and foregoing description, such illustration and description are considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

## Claims

1. A package, comprising:
a support substrate including routing network;
wherein the support substrate includes a center portion and at least one peripheral portion connected to the center portion by a flexible coupling region;
a first circuit device having a front mounted to an upper surface of the support substrate at the center portion and electrically coupled to the routing network;
a second circuit device having a front mounted to the upper surface of the support substrate at the at least one peripheral portion and electrically coupled to the routing network;
a heatsink comprising a base plate, a plurality of fins extending from an upper surface of the base plate and a plurality of tabs extending from a lower surface of the base plate;
wherein the tabs of the heatsink are mounted to the upper surface of the support substrate at the center portion, and the lower surface of the base plate is thermally coupled to a back of said first circuit device;
wherein the at least one peripheral portion is folded relative to the center portion at the flexible coupling region; and
wherein an outer surface of at least one fin of the heatsink is thermally coupled to a back of said second circuit device.

2. The package of claim 1, wherein each tab of the heatsink has a distal end positioned in contact with the upper surface of the support substrate at the center portion.

3. The package of claim 2, further comprising an adhesive material securing the at least one tab of the heatsink to the upper surface of the support substrate at the center portion.

4. The package of claim 1, wherein an outer surface of at least one tab of the heatsink is also thermally coupled to the back of said second circuit device.

5. The package of claim 1, further comprising a ball grid array at a lower surface of the support substrate at the center portion, wherein said ball grid array is electrically coupled to the routing network.

6. The package of claim 1, wherein the first and second circuit devices are integrated circuit dies mounted to the support substrate in flip chip orientation.

7. The package of claim 1, wherein at least one of the first and second circuit devices is a packaged integrated circuit.

8. The package of claim 7, wherein a package for the packaged integrated circuit is quad flat no-leads (QFN) package.

9. A package, comprising:
a support substrate including routing network;
wherein the support substrate includes a center portion and at least one peripheral portion connected to the center portion by a flexible coupling region;
a first circuit device having a front mounted to an upper surface of the support substrate at the center portion and electrically coupled to the routing network;
a second circuit device having a front mounted to the upper surface of the support substrate at the at least one peripheral portion and electrically coupled to the routing network;
a heatsink comprising a base plate and a plurality of tabs extending from a lower surface of the base plate;
wherein the tabs of the heatsink are mounted to the upper surface of the support substrate at the center portion, and the lower surface of the base plate is thermally coupled to a back of said first circuit device;
wherein the at least one peripheral portion is folded relative to the center portion at the flexible coupling region; and
wherein an outer surface of at least one tab of the heatsink is thermally coupled to a back of said second circuit device.

10. The package of claim 9, wherein each tab of the heatsink has a distal end positioned in contact with the upper surface of the support substrate at the center portion.

11. The package of claim 10, further comprising an adhesive material securing the at least one tab of the heatsink to the upper surface of the support substrate at the center portion.

12. The package of claim 9, further comprising a ball grid array at a lower surface of the support substrate at the center portion, wherein said ball grid array is electrically coupled to the routing network.

13. The package of claim 9, wherein the first and second circuit devices are integrated circuit dies mounted to the support substrate in flip chip orientation.

14. The package of claim 9, wherein at least one of the first and second circuit devices is a packaged integrated circuit.

15. The package of claim 14, wherein a package for the packaged integrated circuit is quad flat no-leads (QFN) package.
